# EUROPEAN PATENT SPECIFICATION

(11) **EP 2 591 419 B1**
(45) Date of publication and mention of the grant of the patent: **31.10.2018**
(21) Application number: 10854508.8
(22) Date of filing: 06.07.2010
(51) Int. Cl.: G06F 11/36, G06F 9/445

(54) **SIMULATING AND TESTING AVIONICS**
SIMULATION UND TESTS FÜR LUFTFAHRTELEKTRONIK
SIMULATION ET ESSAI D'AVIONIQUE

(43) Date of publication of application: 15.05.2013
(73) Proprietor: Saab AB, 581 88 Linköping (SE)
(72) Inventor: DANIELSSON, Torkel, S-587 29 Linköping (SE); PETTERSSON, Anders, S-583 37 Linköping (SE)
(74) Representative: Zacco Sweden AB
(86) International application number: PCT/SE2010/050786
(87) International publication number: WO 2012/005639

(56) References cited:
- US-A- 5 541 863
- US-A1- 2003 023 740
- US-A1- 2010 146 487
- US-B1- 6 319 008
- US-B1- 6 319 008
- Edgar Manuel Candido da Silva Pascoal: "AMOBA - ARINC 653 simulator for modular space based applications", University of Lisbon , 2008, pages 1-71, XP002715840, Retrieved from the Internet: URL:http://docs.di.fc.ul.pt/jspui/bitstrea m/10455/3241/1/0708rf_30420.pdf [retrieved on 2013-11-04]
- SCHOOFS T ET AL: "An integrated modular avionics development environment", DIGITAL AVIONICS SYSTEMS CONFERENCE, 2009. DASC '09. IEEE/AIAA 28TH, IEEE, PISCATAWAY, NJ, USA, 23 October 2009 (2009-10-23), pages 1.A.2-1, XP031576000, ISBN: 978-1-4244-4078-8

## Description

### Technical field

The present invention relates to a system and a method for simulating and testing avionics.

Furthermore, the invention relates to software adapted to perform steps of the simulation and test method when executed on a computer.

### Background of the Invention

In embedded control systems of today, developments in digital technology have enabled complex functionality. However as a direct result from the development, the need of additional system capacity provided by software and various components such as sensors, processors, display units, data buses and memory units is increasing.

Apart from implementing more functionality and interconnectivity in control systems, using less Space Weight and Power (SWaP) and a reduced number of cabling are further important drivers. Updates of embedded hardware and software during a products life span make adaptability and modularity another interesting design parameter. Other incentives include achieving cost efficient development, production and maintenance, where one possible route is to implement Commercial-Of-The-Shelf (COTS) technology instead of expensive specialized technology.

Real-time systems for safety critical control applications, wherein typically data from sensor/s are acquired, communicated and processed to provide a control signal to an actuator pose strict demands regarding bandwidth, data delivery time, redundancy, and integrity. Failure to meet one or several of these demands can in applications including "brake-by-wire" or "steer-by-wire" prove dangerous.

One such area wherein reliable high-speed real-time execution and communication of data is applicable is within avionics systems. Advances in technology during late 1960 and early 1970 made it necessary to share information between different avionics subsystems in order to reduce the number of Line replaceable units (LRU:s). A single sensor such as a position sensor provided information to weapon systems, display system, autopilot and navigation system.

The high level architecture of avionics systems has gone from federated meaning separate LRU:s for separate functions to integrated modular avionics (IMA) meaning several functions integrated into multifunctional LRU:s. The connectivity allowing communication between different LRU:s has gone from low bandwidth point-to-point connections to higher bandwidth point-to-multipoint connections.

Guidance set out by Radio Technical Commission for Aeronautics (RTCA) in DO-178B and RTCA DO-254 regulates how to design and develop software and respective hardware in a safe way in order to show airworthiness, according to a criticality scale. However certification and subsequent recertification of software according to the DO-178B represents a substantial cost of developing software based avionic control systems.

In order to assist development of modern control systems for avionics a set of guidance documents such as RTCA DO-297 and Aeronautical Radio Inc. (ARINC) 651 defines general concepts for IMA systems. Further ARINC 653 "Avionics application software standard interface", defines an Application Program Interface (API) referred to as Application Executive (APEX), implemented in Real-Time Operating Systems (RTOS) used for avionic control systems. ARINC 653 allows for space and time partitioning that may be used wherever multiple applications need to share a single processor and memory resource, in order to guarantee that one application cannot bring down another in the event of application failure.

DE102006018181A1 discloses a method that involves controlling communication between a testing function control and interface adjusting routines by using a network distribution routine. The adjusting routines implement interfaces e.g. RS232 interface, of a system under test e.g. control components of an airplane, and generate hardware-and/or software specific interface events as a separate algorithm for the control. The events are generated as the separate algorithm for stimulating the interfaces independent of transmitted testing function information or to use responses of the interfaces for evaluation.

US5111402A1 discloses an integrated aircraft system for functionally testing the components and subsystems of an aircraft during its manufacture and subsequent maintenance. A central control unit serves as a repository for test applications and instruction sets that comprise the individual steps of the functional tests performed on the aircraft. In response to receiving indications of work performed on the aircraft, the central control unit displays an indication of the functional tests that should be performed on the aircraft.

US20080009983A1 discloses flight control system for aircraft and test system for testing such a flight control system. The test system comprises a test device which makes it possible to have access to the information available on a flight control system and to take over at least one computer of that flight control system.

EP0652526A1 discloses an aircraft test system which generates stimuli that emulate the stimuli received by an aircraft when in flight. The aircraft test system includes a number of instruments for generating the number of processor-controllable instruments for generating stimuli received by an aircraft when in flight. The system also includes a number of instruments that monitor the response of the various aircraft components to the stimuli to which the aircraft is exposed.

However, developing avionics software applications tend to require access to target system hardware before any testing and/or simulation of the behavior of the developed avionics applications can be performed. Furthermore access to the target hardware system for testing the developed avionics software applications tends to be a highly limited resource, since many software developers generally partake in the development of applications and each requiring access to test their developed application. Moreover an assembly of the real target hardware system provided for testing purposes typically represents a substantial cost.

Accordingly, there is a need in the art for improvements, intended to facilitate test and simulation of the functionality of avionics software applications.

US20080009983A1 discloses flight control system for aircraft and test system for testing such a flight control system. The test system comprises a test device which makes it possible to have access to the information available on a flight control system and to take over at least one computer of that flight control system.

EP0652526A1 discloses an aircraft test system which generates stimuli that emulate the stimuli received by an aircraft when in flight. The aircraft test system includes a number of instruments for generating the number of processor-controllable instruments for generating stimuli received by an aircraft when in flight. The system also includes a number of instruments that monitor the response of the various aircraft components to the stimuli to which the aircraft is exposed.

"AMOBA - ARINC 653 simulator for modular space based applications", by Edgar Manuel Cândido da Silva Pascoal, is a dissertation dealing with Integrated Modular Avionics (IMA). The dissertation teaches that the main characteristic of IMA is sharing of computation resources ensuring a relevant set of safety and real-time guarantees. Further, the dissertation describes the main research key ideas developed during the design and implementation of a multi-platform and modular ARINC 653 simulator, called AMOBA, which shall emulate an execution environment for ARINC 653 space applications.

However, developing avionics software applications tend to require access to target system hardware before any testing and/or simulation of the behavior of the developed avionics applications can be performed. Furthermore access to the target hardware system for testing the developed avionics software applications tends to be a highly limited resource, since many software developers generally partake in the development of applications and each requiring access to test their developed application. Moreover an assembly of the real target hardware system provided for testing purposes typically represents a substantial cost.

Accordingly, there is a need in the art for improvements, intended to facilitate test and simulation of the functionality of avionics software applications.

### Objective of the Invention

It is therefore an objective of the present invention to provide a system and a method which achieve facilitated simulation and testing of avionics software applications.

### Summary of the Invention

This objective is achieved according to the present invention by an avionics application host system for simulating and/or testing a number of partitioned applications arranged to be periodically executed on a target system, as defined in claim 1.

It is achieved that the partitioned applications arranged to be periodically executed on the target system can be executed within the avionics host system without porting the partitioned applications to the avionics host system. The avionics host system can be used as a desktop simulator tool for developing partitioned applications for control computers. Applications developer can build partitioned applications for the target system and execute the partitioned applications in the simulated environment using the avionics host system. It is further possible to debug the system, to investigate and modify messages and data sent between the partitioned avionics applications. The avionics host system gives the application developers the possibility to test the partitioned applications in a desktop environment before one or more components of the target system hardware or an assembly of the target system hardware is available, developed and/or operable. The avionics host system allow most of the tests associated to integrating the partitioned application into the target system to be investigated and executed directly after build of the partitioned applications at the application developer's desktop.

The system is in one option characterized that the control module is arranged to simulate target system time based on receiving the plurality of requests for execution time from the functional modules and arranged to advance simulated target system time to a subsequent requested start time in rising order.

The system is in one option characterized that the control module is arranged to operate in accordance with a membership protocol and communicate with the functional modules, the partitioned applications and component processes associated to the partitioned applications, based on message queue objects.

The system is in one option characterized that the host system comprises a model module arranged to provide a plurality of physical models of the operating environment of the target system and subsystems coupled to the target system.

The system is in one option characterized that said configuration module is further arranged to provide configuration associating at least one of the number of partitioned applications to at least one variable of at least one the plurality of physical models.

The system is in one option characterized that the at least one communication module comprises a plurality of communication sub-modules and the configuration module further is arranged to provide configuration associating at least one of the number of partitioned applications to at least one variable of at least one the plurality of physical models via at least one of the plurality of communication sub-modules.

By this is achieved that the avionics host system can simulate the entire control system of the aerial vehicle i.e. target system, based on that the partitioned applications can be executed in the avionics host system and interact with simulated subsystem representative of the subsystem associated to the aerial vehicle by using the plurality of physical models such as the models of actuators, sensors and/or operating environment.

The system is in one option characterized that said plurality of communication sub-modules provide communication between component processes associated to each of the number of partitioned applications based on at least a first shared memory object associated to each of the plurality of communication sub-modules and wherein the plurality of communication sub-modules provide communication between the number of partitioned applications associated to different communication sub-modules based on a second shared memory object.

The system is in one option characterized that the at least one communication module is arranged to simulate a time-triggered Ethernet network based on a communication schedule provided by the configuration tables and a second shared memory object associated to the at least one communication module.

The system is in one option characterized that the target operating system is a real-time operating system and the host operating system is a general purpose operating system.

The system is in one option characterized that the number of partitioned applications are ARINC 653 applications and the service module (150) is arranged to provide ARINC 653 functionality.

The system is in one option characterized that the ARINC 653 partition service is mapped to UNIX processes and the partitioned applications are executed within its associated UNIX process as POSIX threads.

This objective is also achieved according to the present invention by a flight simulator comprising an avionics applications host system according to any of claims 1-11, wherein the avionics application host system comprise an input module arranged to provide means to input control commands associated to simulated flight operations and wherein the avionics application host system comprise display means arranged to provide visual feedback based on the simulated flight operations.

By this is achieved that a pilot can operate a virtual version of the aerial vehicle comprising the target system with the partitioned applications based on the avionics host system provided with input means.

This objective is also achieved according to the present invention by a method for simulating and/or testing a number of partitioned applications arranged to be periodically executed on a target system, as defined in claim 11.

The dependent claims define optional characterizing features corresponding to those described in relation to the system.

This objective is also achieved by a computer programme comprising a programme code for performing the above described method steps, when said computer programme is run on a computer.

This objective is also achieved by a computer programme product comprising a program code stored on a computer readable media for performing the above described method steps, when said computer programme is run on the computer.

This objective is also achieved by a computer programme product directly storable in an internal memory of a computer, comprising a computer programme for performing the above described method steps, when said computer programme is run on the computer.

### Brief Description of the Drawings

Fig.1. shows schematically a distributed avionics system in accordance with an example of the invention.
Fig.2. shows schematically the distributed avionics system integrated to components of an aerial vehicle in accordance with an example of the invention.
Fig.3. shows a schematic block diagram of hardware components of the distributed avionics system in accordance with an example of the invention.
Fig.4. illustrates a schematic representation of the hardware components and software in accordance with an example of the invention.
Fig.5. illustrates a schematic representation of a portion of the software architecture in more detail.
Fig.6. shows a schematic illustration of an execution schedule in accordance with an example of the invention.
Fig.7. shows a schematic illustration of a simulation framework in accordance with an example of the invention.
Fig.8. shows a schematic illustration of communication architecture within a simulation framework in accordance with an example of the invention.
Fig.9. shows a schematic illustration of a flow diagram for a method to simulate and/or test a number of partitioned applications in accordance with an example of the invention.

### Detailed Description

The present disclosure describes a system, method and computer program for simulating and testing developed software applications intended to execute on an embedded distributed control computer environment.

The developed software applications comprise source code utilizing one or more functional calls/services associated to functionality provided from the embedded distributed control computer environment. The one or more functional calls/services may for example require functionality provided from one or more particular operating system and/or one or more particular API associated to the embedded distributed control computer environment.

Also the developed software applications may be compiled to machine readable code, such as executable binaries compiled using a compiler, compatible with the embedded distributed control computer environment.

Hence, the source code or machine readable code is sensitive to the specific environment in which the software applications are intended to execute on i.e. requiring target platform specific functionality. The behaviour of the software applications is simulated and/or tested using a replicated target environment referred to as host environment or host system. Furthermore, an entire target system can be virtually tested in a simulated operating environment using models of the operating environment.

The following examples relates to the case with reference to aerial vehicles. However, various different applications are possible, such as for example land, sea or space vehicles.

A simulation or test environment or system is referred to as a "host" environment or system and the intended execution environment or system is referred to as "target" environment. A target environment is the environment in which the software applications are intended to execute and/or is compiled to.

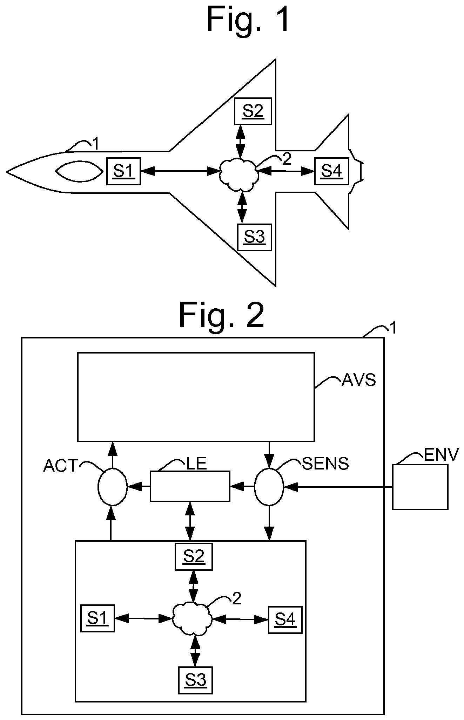

Referring to the drawings, and initially to **fig. 1****,** there is illustrated a target system in accordance with an example of the present invention. The target system is a distributed avionics computer system comprising a plurality of avionics computers **S1-S4** arranged to be mounted in various locations of an aerial vehicle **1** and act as controller of one or more of a set of subsystems of the aerial vehicle **1,** such as for example act as a controller of a fuel injection system or hydraulics of an aileron.

In **fig. 2** there is illustrated an alternative view of the distributed avionics computer system integrated into systems/components of the aerial vehicle **1** in accordance with an example of the invention. The set of subsystems of the aerial vehicle **AVS** may comprise systems such as for example ailerons, flaps, fuel injection and payload. The distributed avionics computer system may comprise at least one computer node **S1-S4,** such as a general purpose computer arranged as a flight control computer (FCC) and/or a mission control computer (MCC), arranged to be in communicative connection with various of the set of subsystems of the aerial vehicle **AVS** and additional systems and/or components such as sensors **SENS,** actuators **ACT** and one or more control stations. The sensors **SENS** may provide information related to properties of various of the set of subsystems of the aerial vehicle **AVS** and of an operating environment **ENV** surrounding the aerial vehicle **1.** The one or more control stations may provide information related to interactions from one or more operators of the aerial vehicle **1.** The distributed avionics computing system may be arranged to process the information provided from one or more of the sensors **SENS** and/or control stations, in order to provide control data to the one or more actuators **ACT** and/or presentation data to the control stations. The distributed avionics computer system may be coupled to at least one legacy avionics processing component **LE,** such as for example a legacy LRU arranged as a radar processing unit, arranged to be in communicative connection with the various avionics subsystems **AVS** and additional systems and/or components such as sensors **SENS,** actuators **ACT** and the one or more control stations.

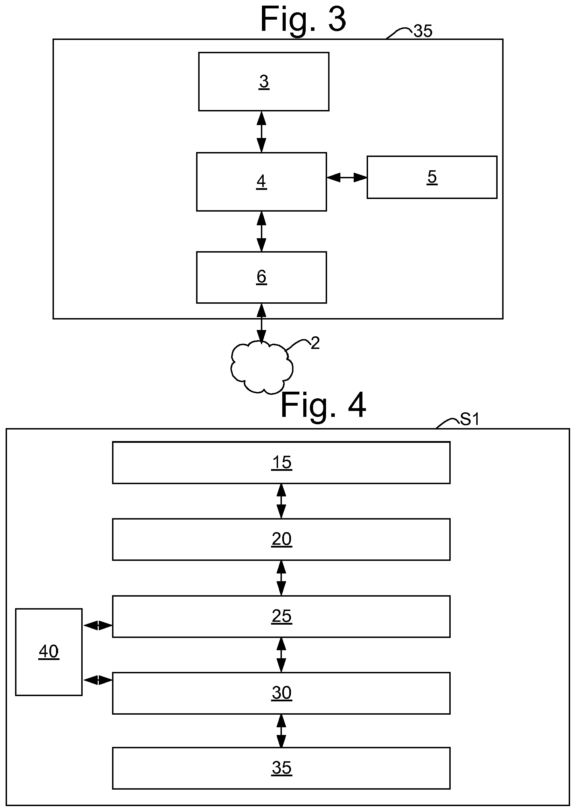

With reference to **fig. 3** the hardware configuration **35** of one of the plurality of computers **S1** of the target system is illustrated in accordance with an example of the invention. Each of the plurality of computers **S1-S4,** hereinafter referred to as nodes **S1-S4,** may comprise at least a processor **4,** memory **3,** hardware clock (not shown), power supply (not shown), bus interface **6** and I/O interface **5.** The I/O interface **5** may be arranged to provide access to system peripherals e.g. devices coupled to the respective node by means of VME, PCIe or the like. The distributed system may further comprise at least one network **2,** such as for example a switched Ethernet network, operatively connecting the nodes **S1-S4,** thereby enabling exchange of data messages between the nodes. Access to the network may be provided by the respective bus interface **6** which may be arranged to place data messages to and/or retrieve data messages from the network **2** in accordance with predetermined instructions. The bus interface **6** may further be arranged to provide access by means of one or more additional connections to other devices such as remote data concentrators (RDC:s), sensors and/or actuators. The one or more connections to the other devices may be point-to-point connections such as RS-422 or of bus type such as MIL-STD-1553, IEEE 1394, or other similar type of connection known within the art.

In **fig. 4** the configuration relating to the high level architecture of one of each of the plurality of computers **S1** of the target system is illustrated in accordance with an example of the invention. Each node **S1-S4** may apart from the above described hardware **35** with reference to **fig. 2** comprise a hardware interface system **30,** arranged to by means of a set of interface drivers to provide access to specific hardware such as the memory **3** and the hardware clock. Each node **S1-S4** may further comprise an operating system **25** such as a real-time operating system RTOS. The operating system may be arranged to provide a number of services to one or more applications associated to the target system. The number of services may relate to communication, scheduling, memory management, timing and health monitoring, such as providing local system time and timer services. In providing the services the operating system may be arranged to interact with the hardware **35** by means of the hardware interface system **30.** Each node **S1-S4** may further comprise a configuration data module (CDM) **40.** The configuration data module **40** may be arranged in operative connection with the operating system **25** and the hardware interface system **30** to provide information stored within the configuration data module relating to specific configuration of memory access, scheduling and communication. As an example the configuration data module may be arranged to provide the RTOS with initialization parameters associated to execution, timing and memory configuration.

Each application of the one or more applications associated to the target system i.e. distributed avionics computer system may comprise one or more tasks, also referred to as processes. Each of the one or more tasks may denote a logical unit of computation with a single thread of control. As an example an application may be arranged to process sensor readings and control commands provided by an operator by means of one or more control laws, to continuously provide a control signal to an actuator, such as to an actuator associated to an aileron. As an example one of the tasks may be configured to perform a derivative operation on a first data variable retrieved from a sensor at time t. As a further example one of the tasks may be configured to perform a computation at time t and t +1 to provide a second data variable relating to a velocity of an object at time t and t + 1 given a first data variable associated to the acceleration of the object at time t and t + 1.

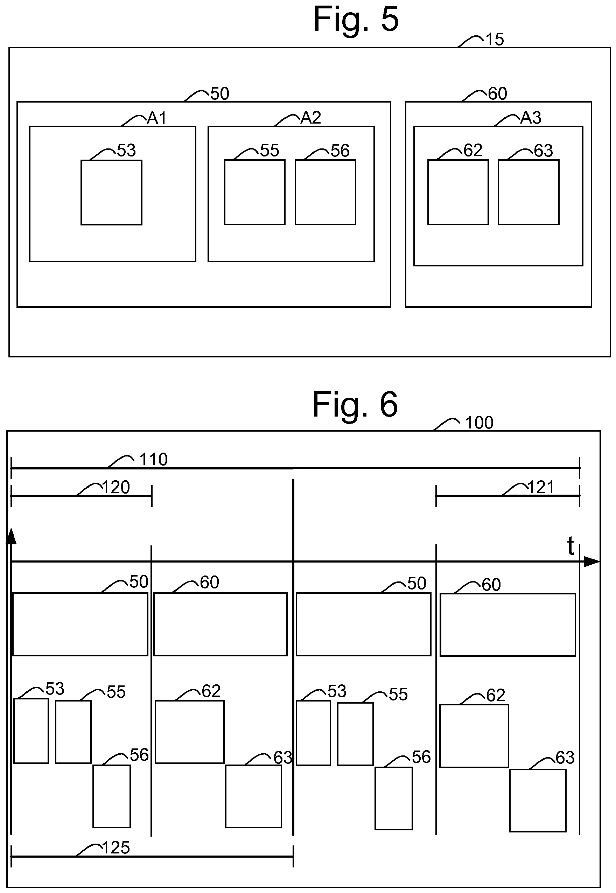

In one example each node **S1-S4** of the target system may be arranged to execute a partitioning real-time operating system RTOS, compliant with ARINC 653, to allow for spatial and temporal partitioning of the set of applications comprised in an integrated modular avionics IMA partitioning module **15.** With reference to **fig. 5** the IMA partitioning module **15** may comprise the one or more applications as partitioned applications, such as for example a first application **A1**, a second application **A2** and a third application **A3.** Each of the applications may be divided in the IMA module **15** into one or more partitions such as for example a first partition **50** associated to the first application **A1** and the second application **A2** and a second partition **60** associated to the third application **A3.** Each of the one or more applications **A1-A3** associated to the target system may further comprise one or more tasks. As an example a first task **53** may be associated to the first application **A1**, a second task **55** and a third task **56** may be associated to the second application **A2** and a fourth task **62** and fifth task **63** may be associated to the third application **A3.** The one or more node **S1-S4** may further each comprise an abstraction layer provided by an application programming interface (API) **20** located between application software in the IMA partitioning module and operating system OS. The API **20** may be arranged to provide a set of basic services to the set of applications required for performing their respective tasks and in order to communicate.

In one the example the API may be arranged as an application executive APEX, conforming to the ARINC 653 specifications. The implementation of the ARINC 653 specifications, for high level IMA architecture prevents error propagation when running different applications on a single processor. The partitioning enables to run applications certified to different criticality level measured by Design Assurance Level (DAL) according to the RTCA DO-178B on a single processor.

In **fig. 6** an execution schedule **100** of partitions associated to one of the nodes in the target system is illustrated in accordance with an example of the invention. The processing resources of the processor **4** in each of the nodes **S1-S4** may be divided by means of configuration into one or more minor execution time frames **125** also referred to as minor processing time frames. Each of the minor execution time frames **125** may be arranged to be periodical i.e. reoccurring periodically at time instants defined by a period time. Each of the one or more partition allocated to the IMA partitioning module **15** in each of the respective nodes may be provided with at least one execution time frame, such as for example a first execution time frame **120** associated to the first partition **50,** providing the partition with exclusive access to the processing resources **4** of the respective allocated node **S1** for the given at least one execution time frame **120.** One or several minor execution time frames may comprise one or more execution time frames associated to the partitions. As an example the one or more minor execution time frame **125** my comprise a first execution time frame **120** associated to the first partition **50** and a second execution time frame **121** associated to the second partition **60.** A major execution time frame **110** may determine the intrinsic repeat cycle of the schedule defined by one or several minor execution time frames **125** in each of the nodes **S1-S4.**

In one example each of the partitions associated to the respective node may be assigned a time frame each of a partitioning schedule, determining the order and execution time frame for processing the partitions within each minor processing frame **125.**

The execution schedule **100** may be utilized by the operating system **25** to determine when to perform context switches between different partitions and the tasks associated to the different partitions by means of clock interrupts provided from the hardware **35.** For example the execution schedule **100** may determine when to perform context switches between the first partition **50** and second partition **60** and the respective associated tasks **53, 55-56, 62-63.**

It should be understood that the configuration regarding the number of applications, tasks, and partitions thereby also the execution frames may differ from the illustrated example with reference to **fig. 6****.**

Determination of the execution schedule **100** for each of the nodes **S1-S4** may be performed by means of considering the computational requirements of the applications and their associated one or more tasks in respect of the resources provided by the nodes **S1-S4.**

During the execution time frame for the specific partition of the one or more partitions, the tasks associated to the specific partition may be executed on a priority basis. Each task may be assigned a task frequency or period, relating to the subsequent executions also referred to as invocations of the task.

In one example each of the tasks of the distributed avionics computing system may be arranged to execute periodically. In order to execute periodically the release time, referring to when a task may start to execute, may be time-triggered at a regular i.e. at a cyclic basis, such as time triggered by means of the timer services provided by the operating system. Each task may then be defined by a set of properties associated to timing, including a period time T defining the time interval between successive releases of the task, a completion time (CT) defining the time when the task completes its execution, a deadline (D) defining the latest time when the task should complete its execution and a worst case execution time (WCET) defining the time needed to execute the task without interruption.

In one example the execution order of the one or more tasks during the execution time frame allocated to the partition may be scheduled by a priority-based pre-emptive scheduler such as scheduled in order of decreasing process frequency i.e. the tasks in each partition are executed on a rate-monotonic (RM) priority basis.

In one example the execution order of one or more tasks during the execution time frame allocated to the partition may be scheduled on a deadline-monotonic (DM) basis i.e. tasks are scheduled in order of increasing deadline for task completion.

The priority-based pre-emptive scheduler may be arranged to interrupt task execution, when some higher-priority task needs to be executed and resume it at a later instant of time. In a case wherein several tasks being assigned to the same partition are assigned with the same update frequency, first-in-first-out (FIFO) order may be used to determine internal order of execution. Hence, the execution of applications on each local node may be arranged to be controlled by a two level scheduler. The first level scheduler is arranged to schedule pre-emption of the local partitions determined from the predetermined execution time frames for each of the partitions residing in the IMA partitioning module **15** of the respective local node **S1-S4.** To determine the order of execution of the partitions, static predetermined priorities may be assigned to the partitions prior to system run-time. The second level scheduler is arranged to schedule the one or more tasks within each of the partitions on a priority pre-emptive basis during the predetermined execution time frame for the partition. As an example the first partition **50** may be allocated to a first node **S1** and assigned with the first execution time frame **121** of for example 10 ms and with a period of 25 ms corresponding to a repeat i.e. update frequency of 40 Hz. The first task **53,** second task **55** and third task **56** may be associated to the first partition **50**. The first and second task may be assigned with a task frequency of 40 Hz and the third task may be assigned with a task frequency of 20 Hz. The second partition **60** may be allocated to the node **S1** and assigned with the second execution time frame **120** of for example 12 ms and with a period of 25 ms corresponding to a repeat i.e. update frequency of 40 Hz. The fourth task **62** and fifth task **63** associated to the second partition **60** may be assigned with a task frequency of 40 Hz and 20 Hz respectively. Hence, the instances of the first task **53** and the second task **55** are executed once each 25 ms time period, the instances of the third task **56** are executed once each 50 ms time period. The instances of the fourth task **62** are executed once each 25 ms time period and the instances of the fifth task **63** are executed once each 50 ms time period. The major time period **110** for the schedule may then be determined to be the least common multiple of the execution time period of each of the tasks associated to each of the nodes **S1-S4,** such as for example the least common multiple of 25 ms and 50 ms corresponding to 50 ms, which is the time period where after the sequence of execution of task instances i.e. schedule may repeat cyclically. It is to be noted that one or more task instances, such as the instance of the third task **56** and fifth task **63** may be pre-empted during a first execution of its associated partitions **50, 60** and later be resumed during a subsequent execution of its associated partition **50, 60.** The third task **56** may for example be pre-empted depending on if the CT of the third task **56** together with the CT of one or more other tasks residing in the same partition such as for example the CT of the first task **53** and second task **55** exceeds the time period assigned to the respective partition **50.**

In one example the task processing frequency may be configured to be selected from a harmonic set of frequencies with corresponding periods such as for example the set of frequencies comprising 40 Hz, 20 Hz, 10 Hz and 5 Hz. The task processing frequency may be selected on basis of the respective task requirements for frequent execution time.

In one example the set of task processing frequencies is provided as a set of system global processing frequencies. Hence, all tasks distributed across the distributed system of interconnected nodes **S1-S4** may be assigned with a task processing frequency each, selected from the set of predetermined global task processing frequencies. Thus, all tasks distributed onto the one or more nodes **S1-S4** are assigned with one processing frequency and/or processing period time each, determined from the set of global processing period frequencies.

In one example the task processing frequency of each specific task may be selected on basis of how often input data are updated or how often subsequent input data significantly changes in its parameter value.

In one example the task processing frequency of each specific task may be selected on basis of how often output data from the process is required by other parts of the system.

In one example the task processing frequency of each specific task may be selected on basis of a combination of how often input data are updated or how often subsequent input data significantly changes in its parameter value and/or how often output data from the process is required by other parts of the system

In one example information to be provided to the configuration data module **40** associated to each of the nodes **S1-S4** of the target system may be constructed and/or managed using a set of configuration files. The set of configuration files may provide various elements of the distributed avionics computer system with configuration information relating to scheduling, memory access and communication. The set of configuration files may for example provide the information to the operating system OS and/or hardware interfaces and/or other components of the respective system nodes **S1-S4.** Construction of the set of configuration files may be performed in several ways using different forms. The configuration files may for example be in the form of some programming language data declarations, in general markup language form such as for example in eXtensible Markup Language (XML), or in some text-based proprietary format.

In one example the set of configuration files may be constructed using model based development tools.

In one example a first subset of the set of configuration files may be automatically generated based on a second subset of the set of configuration files.

The configuration data from the configuration files associated to partitioning of the set of applications and other OS related attributes can later be linked to and compiled with source code associated to for example the set of applications to provide executable files in machine readable format.

In one example the configuration files may be compiled into binary format using a RTCA DO-178B certified compiler.

In one example a subset of the set of configuration files may be associated to an ARINC 653 implementation associated to each of the nodes **S1-S4.** The subset of configuration files, may describe the characteristics of partitions, their interactions, and their time and resource requirements. After the subset of configuration files is loaded and processed, the ARINC 653 based RTOS associated to each of the nodes **S1-S4** may provide the behavioral ARINC 653 support by allocating memory for the system partitions, setting up memory protection structures, and allocating other system resources.

In one example of the present invention additional configuration data may be constructed from a set configuration files comprising a number of subsets of configuration files. Each of the subset of configuration files may comprise one or more configuration file associated to one of a group comprising system hardware topology, software topology, data messages, system timing, and applications.

In one example each of the configuration files from the subset of configuration files may be used as input data to a set of operational tools. The set of operational tools may be arranged to process information extracted from one or more of each of the configuration files so as to automatically provide the additional configuration data related to for example connectivity between the set of applications.

In one example the set of operational tools may be arranged to provide machine readable configuration data associated to connectivity. The machine readable configuration data associated to connectivity may comprise instructions relating to I/O traffic for control of various I/O mechanisms arranged to operate within the distributed avionics computer system such as for example at least an I/O partition or I/O processor associated one or more of each of the nodes **S1-S4.**

As a result of the operations of the set of operational tools the preconfigured traffic schedule may be generated automatically off-line for each of the nodes **S1-S4** as a static description of the network transactions within a major bus period that is periodically repeated. The preconfigured traffic schedule is statically determined i.e. it is predetermined from the allocation of each of the one or more data messages into the plurality of communication time-slots when each of the one or more data messages is sent onto the network **2.** It is further predetermined which of the one or more data messages that comprise which one or more data variable. The preconfigured traffic schedule can be generated for a predetermined distributed avionics computer system based on configuration files comprising configuration data associated to configuration of hardware and software.

The operational tools may in one example be implemented as software operating in a computer environment separated from the distributed avionics computer system.

In one example a host system is provided in accordance with an example of the invention. The host system may comprise standard hardware associated with one or more general purpose computer, such as for example hardware found in a typical workstation, desktop, laptop or server. The host system may comprise a plurality of general purpose computers interconnected in a network. The host system may comprise one or more general purpose operating system (GPOS) to provide an interface to services from the one or more general purpose computers. Each of the one or more general purpose computers may comprise typical components such as for example one or more processor, memory, backplane or other additional computer components known within the art.

In one example the host OS may be a non real-time GPOS such as for example the Windows® XP OS available from Microsoft Corporation, MAC OS System X available from Apple Computer, Solaris OS available from Sun Microsystems, UNIX available from various sources or Linux available from various sources.

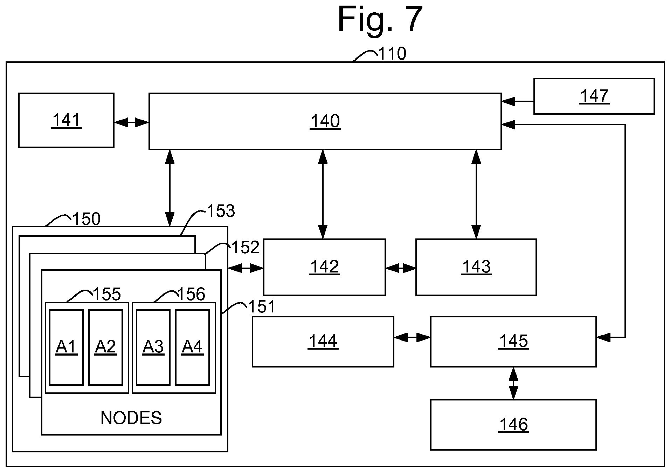

With reference to **fig. 7** there is illustrated a simulation framework **110** arranged to be orchestrated inside the host system in accordance with an example of the present invention. The simulation framework is arranged to interface with the OS and hardware associated to the host system in order to provide an interface to execute one or more applications **A1-A4** associated to the target system based on un-modified application source code or un-modified binaries associated to the one or more applications wherein the binaries are compiled for the target system. By providing the interface to execute the one or more applications **A1-A4** using un-modified application source code or un-modified binaries compiled for the target system the simulation framework **110** provide means for host based simulation of the behavior of the one or more application orchestrated in the target system.

In one example the simulation framework **110** may provide means for host based simulation of interaction between the one or more applications associated to the target system and the set of subsystems **AVS** coupled to the target system.

In one example in order to provide the interface to execute the one or more target software applications the simulation framework is arranged to provide a number of system services needed for execution of the target software applications based on un-modified target software application source code.

In one example in order to provide the interface to execute the one or more target software applications in un-modified binary format compiled for the target system the simulation framework may be arranged to provide an instruction set simulation (ISS) representative of the instruction set architecture (ISA) of the target system.

In one example the number of system services provided by the simulation framework may correspond to one or more system service defined by the API of the ARINC 653 specification referred to as application executive (APEX). The one or more system service can according to the specification each be related to a number of major categories comprising partition management, process management, time management, intra-partition communication, inter-partition communication and health monitoring.

In one example the simulation framework **110** comprise a simulation module **140** arranged to provide coordinated activation of a number of functional modules comprised in the simulation framework **110.** The functional modules may be software objects, such as for example executable software objects. The coordinated activation of the functional modules may refer to providing processing resources, communication resources and memory resources. The simulation module **140** may for example provide processing resources available to the host system to one or more of the functional modules at predefined instants of time according to a simulation schedule. One or more functional modules may be active at the same time.

In one example the simulation module **140** may comprise a time-server arranged to provide a cyclic based execution model. In one example the time-server is arranged to divide the overall processor capacity, available to the host system between the different partitions **50, 60** associated to the one or more applications **A1-A4** associated to the target system.

In one example the simulation framework comprise a monitor module **141** arranged to provide means for supervision and monitoring of processes associated to the simulation framework and the number functional modules during active simulation and/or during configuration of the simulation framework **110.** As an example the monitor module **141** may be arranged to visualize configuration and characteristics associated to the target system in a first window of a graphical user interface (GUI) and behavior of the target applications during run-time in a second window of the GUI.

The simulation framework may comprise a virtual platform module **142** arranged to simulate one or more component of the target system i.e. distributed avionics computer system. The virtual platform module **142** may for example be arranged to simulate behavior of one or more network **2** and/or communication bus arranged to interconnect the distributed avionics computer system. The virtual platform module **142** may be arranged to operate in conjunction with network i.e. communication characteristics provided from a configuration module **145.** The communication characteristics may comprise bandwidth, latencies and protocol. As an example the virtual platform module may be arranged to simulate a physical switched Ethernet network, arranged to implement a time divisional multiple access (TDMA) protocol.

In one example the virtual platform module **142** may be arranged to provide simulation of additional components, such as for example a primary flight data (PFD) display arranged to provide visual information based on ARINC 661 display data streams provided from target applications and/or a simulated physical operating environment.

In one example the simulation framework **110** comprises a model library module **143.** The model library module **143** comprise information related to a number of physical models of one or more systems to which the distributed avionics control system i.e. target system is coupled and arranged to interact with. The physical models may for example be models of the set of subsystems of the aerial vehicle **AVS,** such as for example a mathematical model describing a fuel system with associated variables relating to fuel consumption, maximum fuel capacity and current fuel supply. The physical models may further comprise models representing the physical environment in which the aerial vehicle is intended to operate. The models associated to the environment may relate to models of aerodynamic effects acting on the aerial vehicle based on variables such as for example altitude, attitude and actuator positions. The models of aerodynamics may for example comprise six degrees of freedom (6-DOF) flight dynamics.

In one example the model library module **143** may comprise a model state module. The model state module may be arranged to update variables and/or states associated to the physical models of the model library module during simulation run-time in response to received data and/or in response to timed events. The model state module may be communicatively coupled to the virtual platform module **142** in order to provide means for two-way communication between the one or more applications **A1-A4** and the model library module **143.** The communication between the one or more applications **A1-A4** and the model library module **143** may comprise variables related to properties associated to the physical models representative of properties of the subsystems and/or environment of the aerial vehicle.

In one example the simulation module **140** is coupled to a configuration module **145** arranged to configure the simulation framework **110.** The configuration module **145** is coupled to a configuration table loader module **144,** arranged to import configuration tables or configuration data comprising information of table-driven operations associated to the target system and/or the target applications. The configuration tables may specify operations relating to processing, communication and memory access, these tables can be used as inputs to the configuration manager to define the characteristics of the target system. As an example the characteristics of the target system may comprise characteristics associated to I/O allocation, routing, data format conversion, bandwidth limitations, I/O data formats, scheduling of partitions, memory allocation, memory limitations, health monitoring reactions and general node characteristics such as for example cache memory size and random access memory (RAM) size. The configuration tables may for example be imported into the simulation framework **110** by parsing configuration files in a XML format into machine readable instructions. The configuration module is further coupled to an application loader module **146** arranged to import the target applications. The one or more applications **A1-A4** can be imported into the application service module **150** in un-modified format i.e. the target applications can be imported using un-modified source code.

In one example the configuration module **145** may be arranged to configure connectivity between at least one of the one or more applications **A1-A4** and at least one of the variables and/or state associated to one of the physical models of the model library module **143.** As an example at least a first application arranged to control fuel injection in the target system may be configured in the simulation framework **110** to provide control commands via the virtual platform module **142** to at least a first physical model descriptive of the fuel in the fuel tank and at least a second physical model descriptive of jet engine propulsion. The at least second physical model may further be configured in the simulation framework **110** to provide variables related to the currently provided engine power via the virtual platform module **142** to at least a second target application arranged to control thrust.

In one example the simulation framework **110** comprise a test module **147** arranged to provide means for functional and behavioral testing of the one or more applications **A1-A4** associated to the distributed avionics computer system. The test module may for example comprise a number of predetermined test scripts, configurable scripts and/or test functions which may be activated and/or manipulated by a user of the simulation framework **110.** As an example the test module may **147** provide a fault-injection-test functionality allowing one or more fault condition to be inputted to one or more of the target applications during simulation run-time in order to test robustness.

In one example an application service module **150** is provided. The application service module **150** is arranged to host the partitioned target applications **A1-A4** grouped in a number of virtual partitions **155-156** associated to a number of virtual nodes **151-153** corresponding to the configuration of the target system. The application service module **150** is arranged to provide services required for executing the one or more application **A1-A4** in correspondence with the imported target configuration tables. The application service module **150** may be arranged to host the target applications in one or more memory areas associated to the host system.

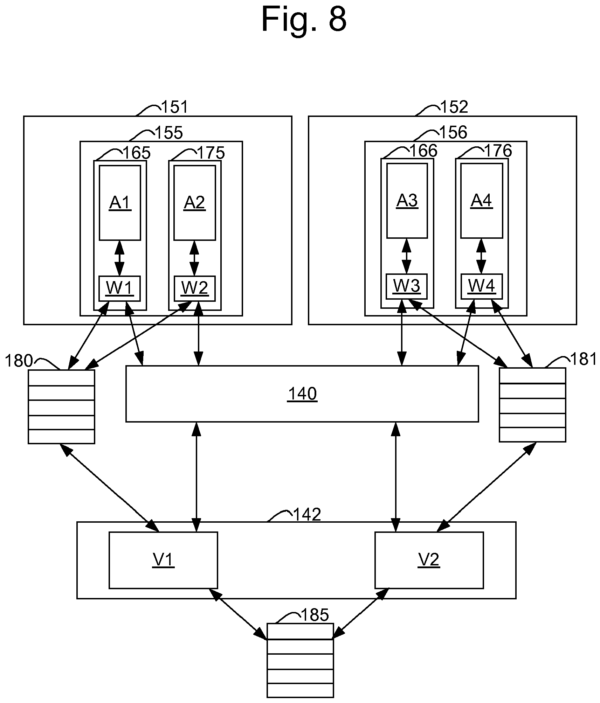

In one example with reference to **fig. 8** each of the one or more applications associated to the target system are provided with a wrapper layer **W1-W4**. The wrapper layers associated to the one or more applications **A1-A4** are arranged to provide an interface to the functional modules of the simulation framework **110** such as for example the simulation module **140** and the virtual platform module **142.** Each of the number of wrapper layers are arranged to wrap services requested from the one or more applications **A1-A4** via the APEX API onto the services provided by the simulation framework **110** such as for example services related to process control and communication.

In one example the virtual nodes **151-153** in the host system corresponding to the nodes **S1-S3** in the target system may be implemented as a group of UNIX processes, one for each virtual partition **155-156** allocated to the respective virtual node.

In one example each of the one or more applications **A1-A4** may be implemented as POSIX threads. Each of the POSIX threads may be arranged to execute within the UNIX process associated to each of the virtual partitions **155-156.**

In one example an init process may be associated to each UNIX process. Each of the init processes may be arranged to create the POSIX threads associated to the target applications. Information about the target applications in each of the virtual partitions i.e. UNIX processes can be retrieved by the init process via the configuration tables associated to the target system.

In one example one or more communication sub-module **V1-V2** associated to the virtual platform module **143** may be arranged to execute target software I/O instructions, such as for example I/O instructions arranged to be loaded to and executed within one or more embedded I/O mechanism associated to the target system. The one or more communication sub-module **V1-V2** may further each comprise a porting layer. The porting layer may be arranged to provide means for communication between the target applications executing in the host system using target I/O routines based on providing one or more replacement routine. The porting layer comprise replacement routines for low level routines such as for example direct memory access (DMA) schemes, I/O routines, MIL-STD 1553 and alternative interfaces to the virtual nodes **151-153.**

As an example relating to the case wherein the nodes **S1-S4** associated to the target system each comprises a dedicated I/O controller (IOC) or dedicated I/O processor (IOP) coupled via PCIe interface, the one or more communication sub-module **V1-V2** may be arranged to import and execute routines associated to the target IOP or IOC. The memory associated to the PCIe interface in the target system used for communication using DMA between the IOP/IOC and the one or more applications in target system may for example be replaced in the host system by a shared memory **180-181.** The shared memory may be implemented as for example a POSIX shared memory with the same memory size and memory layout as in the target system. Configuration of the POSIX shared memory may be arranged to be performed based on using the configuration tables associated to the target system.

In the illustrated example with reference to **fig. 8** a first application **A1** and a second application **A2** associated to a first virtual node **151** are arranged to communicate with a first communication sub-module **VI** using a first shared memory **180** via an associated first wrapper layer **W1** and a second wrapper layer **W2** respectively. A third application **A3** and a fourth application **A4** associated to a second virtual node **152** are arranged to communicate with a second communication sub-module **V2** using a second shared memory **181** via an associated third wrapper layer **W3** and a fourth wrapper layer **W4** respectively. The first application **A1** and second application **A2** are arranged to execute as a first thread **165** and a second thread **175** respectively within a first virtual partition **155.** The third application **A3** and fourth application **A4** are arranged to execute as a third thread **166** and a fourth thread **176** respectively within a second virtual partition **156.** The virtual partition **155-156** may be implemented as UNIX processes and the target applications **A1-A4** may be implemented as POSIX threads. The first communication sub-module **VI** and the second communication sub-module **V2** are arranged to provide means for communication between the first virtual node **151** and the second virtual node **152.** Communication can be provided between the first and second virtual node **151-152** based on a third shared memory **185.** Communication using the third shared memory **185** and/or additional routines associated to the porting layer of the first communication sub-module **VI** and the second communication sub-module **V2** may replace communication associated to the target system using a physical switched Ethernet network interconnecting the nodes **S1-S4.**

In one example the communication sub-modules **V1-V2** are arranged to provide simulation of inter-partition communication using ARINC 653 sampling and/or queuing ports.

In one example the simulation module **140** may utilize synchronization objects such as for example semaphores to coordinate the activation of the functional modules.

In one example the simulation module **140** may be arranged to implement a membership protocol arranged to coordinate the activation i.e. execution of the functional modules and/or component processes associated to the functional modules. The component processes associated to the functional modules may for example comprise the POSIX threads and/or UNIX processes.

In one example the functional modules and/or component processes associated to the functional modules are arranged to request execution time through the time-server. The time-server is arranged to control progression of simulated target system time and determine which of the functional modules and/or component processes associated to the functional modules that are next in order to be released i.e. executed.

In one example each of the members may be arranged to request a time to execute from the time-server based on configuration data associated to the target system. As an example each member may repeatedly request a time to execute based on the processing period or frequency allocated to processing components, such as for example tasks, threads and/or processes associated to the member.

In one example message queues are used for sending messages between the time-server and the members i.e. the functional modules and/or component processes associated to the functional modules registered as members. One message queue is used for each receiver of messages, i.e. one message queue is associated to the time-server and one message queue is associated to each member. The message queues may be initialized and created for every functional modules and/or component processes associated to the functional modules independently of each other. The initialization of message queues is controlled via membership request from the functional modules and/or component processes associated to the functional modules to the time-server, wherein time-server can determine if the membership already exists or not. In on one example a preconfigured global queue is initialized via the time-server to control all incoming requests to the time-server.

When the functional modules and/or component processes associated to the functional modules requests execution time from the time-server, the functional modules and/or component processes associated to the functional module is arranged to listen to its associated message queue for a message sent from the time-server granting the member permission to execute. Before the message granting the member permission to execute is sent from time-server the member will be in blocking mode. Thus, blocking message queue reads can be used as a mechanism to stop member execution until the time-server grants the member permission time to execute. After each member has completed its processing i.e. execution cycle, the member will request a new execution time and stop listening for the message granting the member permission to execute.

In one example read and write operations can be performed to the message queues both in blocking and non blocking mode.

In one example a state-machine is used to process requests from the members arriving via the preconfigured global queue, associated to the time-server. The state machine is arranged register information related to the members in a member module and determine the order of execution in a scheduler module. The information related to the members may comprise identity and scheduling data. The time-server is arranged to perform transitions between at least two states associated to the state machine. A first state also referred to as a waiting state, comprises waiting for messages to arrive on its associated message queue. When the time-server receives a message and subsequently un-pack the message, a transition to a second state is performed. When the action such as for example execution process requested by the message is performed the time-server return to the first state.

In one example the virtual platform module **142** may be arranged to request execution time from the simulation module **140** based on configuration data associated to one or more communication protocol. As an example the virtual platform module **142** may be arranged to request execution time based on one or more timed events from a predetermined time-slot schedule traffic schedule associated to the target system. The execution time may be requested by the virtual platform module **142** using the porting layer.

In one example in response to receiving execution time for a particular timed event the virtual platform module **142** may be arranged to determine which variables to send to the model state module.

In one example in response to receiving execution time for a particular timed event the first communication sub-module **VI** of the virtual platform module **142** may be arranged to determine which variables to send to the model state module and/or to the second the second communication sub-module **V2.**

In one example the model state module associated to the model library module **143** may be arranged to request execution time from the simulation module **140.**

In one example the model state library may be arranged to request execution time from the simulation module **140** on a periodic basis, such as for example on a 40 Hz basis.

In one example the model state library may be arranged to request execution time from the simulation module **140** based the one or more timed events from the predetermined time-slot schedule traffic schedule associated to the target system determining the flow of data i.e. variables received from the virtual platform module **142.**

In one example the model state module may be arranged to request execution time based on properties of the physical model such as for example a fixed or a variable time step associated to one or more differential equation associated to the physical models.

In one example in response to receiving permission to execute the mode state module may be arranged to process one or more of the physical models to provide updated variables based on variables received variables and/or based on the progression of time.

In one example the time-server may be arranged to implement a non-linear, but always incrementing simulated target system time. The simulated target system time may be controlled by the time-server based on receiving time requests from the members and moving time forward to the next requested time. Thus, the simulated target time advance as fast as it can with respect to the current work load and available computing resources associated to the host system. Thus, the simulated target system time reflects the difference in capacity between processing resources associated to the host system and the target system the in order to maintain a correct sequence of data flow in relation to the target system.

In one example the time-server may comprise a scheduler arranged to determine the correct order of member execution. The order may be calculated based on the requested start times and/or expected end times sent to the time-server by the members. Each time one or more of the members is done executing or requests time to execute the state machine is arranged to query the scheduler to determine which member that is to be executed next in order. The requested start times and/or expected end times may be included in the messages sent to the time-server by the members.

In one example the requested start times and/or expected end times may determined from the configuration tables associated to the target system.

In one example the time-server is arranged to be in the waiting state until all registered members have requested a time to execute.

In one example a scale factor may be applied to the simulated target system time associated to the time-server in order to enable speeding up or slowing down the execution of the target applications. The scale factor may be modified during execution by the interacting with the configuration module **145.**

In one example the host system may comprise additional modules arranged in the model library module **143** and/or simulation module **140** in order to provide the possibility for flying virtually. The additional modules may comprise information and processing components arranged to provide environmental maps and three-dimensional graphics in response to orchestration of the target applications in the host system and/or in response to input control commands. The additional modules may further comprise information and/or processing components arranged to provide virtual mission scenarios and/or operating scenarios, so as to allow an operator to fly virtual missions. The mission scenarios may for example include entities such as virtual opponents and/or "friends". This allows operators such as pilots to test system functionality before implementing it in the target system.

In one example the host system can be coupled to an assembly cockpit mock-up assembly. The cockpit mock-up assembly may comprise various components typically found in the cockpit of aerial vehicles such as knobs, joysticks, display devices and gages. The components may be coupled to the host system to provide means for simulated flight in real-time based on the orchestration of target application in the host system.

In one example the host system may comprise a non-volatile memory, a data processing device such as a microprocessor and a read/write memory. The non-volatile memory has a first memory portion wherein a computer program, such as an operating system, is stored for controlling the function of the distributed avionics computing system. Further, the host system comprises a bus controller, a serial communication port, I/O-means, an A/D-converter, a time date entry and transmission unit, an event counter and an interrupt controller. The non-volatile memory also has a second memory portion.

A computer program comprising routines for controlling the function of the distributed avionics computing system is provided. The program may be stored in an executable manner or in a compressed state in a separate memory and/or in the read/write memory.

When it is stated that the data processing device performs a certain function it should be understood that the data processing device performs a certain part of the program which is stored in separate memory, or a certain part of the program which is stored in read/write memory.

The data processing device may communicate with a data port by means of a first data bus. The non-volatile memory is adapted for communication with the data processing device via a second data bus. The separate memory is adapted to communicate with data processing device via a third data bus. The read/write memory is adapted to communicate with the data processing device via a fourth data bus.

When data is received on the data port it is temporarily stored in the second memory portion. When the received input data has been temporarily stored, the data processing device is set up to perform execution of code in a manner described above. According to one example, data received on the data port comprises information regarding which of the target applications to import into the host system, configuration data associated to the target system and configuration data associated to the interactions between the target system and the target applications. This information can be used by the host system so as to orchestrate the target application associated to the target system i.e. the distributed avionics computing system in the host system so as to simulate and/or test the behaviour of the target applications orchestrated in the target system.

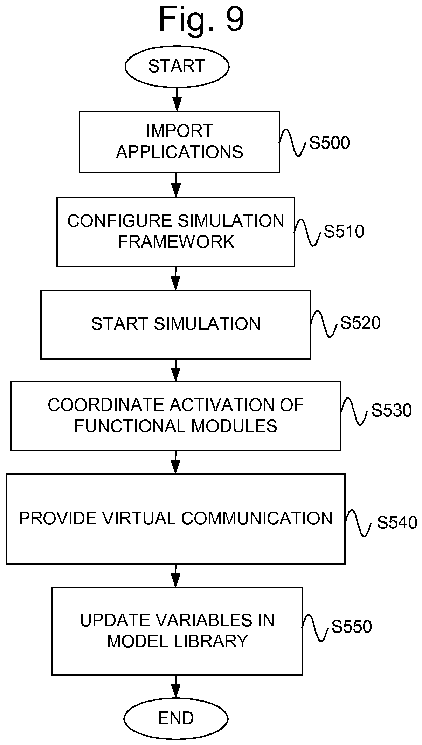

An example of the invention relates to a computer programme comprising a programme code for performing the method steps depicted with reference to **fig. 9****,** when the computer programme is run on a computer.

An example of the invention relates to a computer programme product comprising a program code stored on computer-readable media for performing the method steps depicted with reference to **fig. 9****,** when the computer programme is run on the computer.

An example of the invention relates to a computer programme product directly storable in an internal memory of a computer, comprising a computer programme for performing the method steps depicted with reference to **fig. 9****,** when the computer programme is run on the computer.

**Fig. 9** schematically illustrates a flow diagram of a method according to an example of the present invention. This example relates to simulating and/or testing a number of partitioned applications arranged to be periodically executed on a target system wherein the target system is a distributed avionics system of an aerial vehicle **1.**

In a first method step **S500** the target applications are imported into the host system. This means that the one ore more applications associated to the target system are imported into the host system in un-modified form such as for example using un-modified source code or source code compiled using a compiler, compatible with the target system i.e. distributed control computer environment. After the method step **s500** a subsequent method step **s510** is performed

In the method step **S510** the simulation framework **110** is configured. This means that target system characteristics is provided to the host system via the configuration module **145.** The target system characteristics may be provided to the host system using configuration tables associated to the target system. After the method step **S510** a subsequent method step **S520** is performed.

In the method step **S520** simulation is started. This means that entities associated to the target applications such as for example the UNIX processes, POSIX threads and the virtual platform module are initialized and start provide requests for membership to the simulation module **140.** The simulation module **140** then grants membership and register each of the entities as a member. After the method step **S520** a subsequent method step **S530** is performed.

In the method step **S530** activation of the functional modules are coordinated. This means that the members request execution time from the simulation module **140.** Each request for execution time comprises information on the instant of time when the member is scheduled to start executing. The simulation module **140** then grants permission for the member to execute and adjust simulated target system time forward to the instant of time requested by the member. The simulation module **140** control the execution order among the members based on the requested instant of time to execute and the current simulated target system time. After the method step **S530** a subsequent method step **S540** is performed.

In the method step **S540** virtual communication is provided. This means that the virtual platform module **142** and/or communication sub-module **V1-V2** provides requests for permission to execute to the simulation module **140.** Each request for execution time from the virtual platform module comprises information on the instant of time when the virtual platform module is scheduled to start executing determined from configuration data, related to for example the predetermined traffic schedule. The simulation module **140** then grant permission to execute based on current simulated target system time. After the method step **S540** the method ends in one example and may be repeated starting with the method step **S500** to perform a new simulation or test session.

In another example the method step **S540** is followed by that a subsequent method step **S550** is performed. In the method step **S550** variables in the model library is updated. This means that the model library module **143** provides requests for permission to execute to the simulation module **140.** Each request for execution time from the model library module **143** comprises information on the instant of time when the model library module **143** is scheduled to start executing determined from configuration data, related to for example the predetermined traffic schedule and/or the fixed or the variable time step associated to one or more differential equation associated to the physical models. After the method step **S550** the method ends in one example and may be repeated starting with the method step **S500** to perform a new simulation or test session.

Many modifications and variations will be apparent to practitioners skilled in the art without departing from the scope of the invention as defined in the appended claims. The examples were chosen and described in order to best explain the principles of the invention and its practical applications, thereby enabling others skilled in the art to understand the invention for various examples and with various modifications as suited to the particular use contemplated.

## Claims

1. Avionics application host system for simulating and/or testing a number of partitioned applications (A1-A4) arranged to be periodically executed on a target system, wherein the target system is a distributed avionics control system of an aerial vehicle (1), wherein each of the applications is divided into one or more partitions, and wherein each application comprises one or more tasks, the host system comprising a number of functional modules, wherein the number of functional modules comprises:
- an application module (146) arranged to import said number of partitioned applications (A1-A4) in un-modified binary format compiled for the target system,
- a configuration module (145) arranged to configure the operations of the host system, based on configuration tables associated to the target system, wherein said configuration of the operations relates to specifications of execution, communication and memory access associated to the partitioned applications (A1-A4),
- at least one communication module (142) associated to the imported partitioned applications arranged to provide communication between the partitioned applications and between component processes within the partitioned applications, based on said configuration tables,
- a control module (140) arranged to provide coordinated execution time to the functional modules, based on receiving a plurality of requests for execution time from the functional modules, wherein each of the plurality of requests comprise information related to requested execution start-time, wherein the control module further is arranged to determine the order of execution among a plurality of requests, based on said requested execution start-time,
- a service module (150) associated to each imported partitioned application (A1-A4) arranged to provide services to the imported partitioned applications (A1-A4) related to execution and communication via standard target application interface, based on wrapping requests for services from the imported partitioned applications (A1-A4) via a number of wrapper objects (W1-W4) on to the communication module (142) and control module (140), so as to enable execution of the imported partitioned applications (A1-A4) and to preserve the temporal order of events related to communication and execution **characterized in that** the communication module (142) is arranged to request execution time based on one or more timed events from a predetermined traffic schedule associated to the target system, wherein static predetermined priorities are assigned to partitions prior to system run-time, to determine the order of execution of the partitions, such that during the execution time frame for the specific partition of the one or more partitions, the tasks associated to the specific partition is executed on a priority basis and each task is assigned a task frequency, wherein the task processing frequency is selected from a harmonic set of frequencies and wherein the task processing frequency of each specific task is selected on basis of how often input data are updated or how often subsequent input data changes in its parameter value and/or how often output data from the process is required by other parts of the system.

2. Avionics application host system according to claim 1, wherein the control module (140) is arranged to operate in accordance with a membership protocol and communicate with the functional modules, the partitioned applications and component processes associated to the partitioned applications, based on message queue objects.

3. Avionics application host system according to any of the preceding claims, wherein the host system comprises a model module (143) arranged to provide a plurality of physical models of the operating environment (ENV) of the target system and subsystems (AVS, SENS, ACT) coupled to the target system.

4. Avionics application host system according to claim 3, wherein said configuration module (145) is further arranged to provide configuration associating at least one of the number of partitioned applications (A1-A4) to at least one variable of at least one of the plurality of physical models.

5. Avionics application host system according to claim 4, wherein the at least one communication module (142) comprises a plurality of communication sub-modules (V1-V2) and the configuration module (145) further is arranged to provide configuration associating at least one of the number of partitioned applications (A1-A4) to at least one variable of at least one the plurality of physical models via at least one of the plurality of communication sub-modules (V1-V2).

6. Avionics application host system according to claim 5, wherein said plurality of communication sub-modules (VI-V2) provide communication between component processes associated to each of the number of partitioned applications (A1-A4) based on at least a first shared memory object (181-182) associated to each of the plurality of communication sub-modules (V1-V2) and wherein the plurality of communication sub-modules (VI-V2) provide communication between the number of partitioned applications associated to different communication sub-modules (V1-V2) based on a second shared memory object (185).

7. Avionics application host system according to any of the preceding claims, wherein at least an operating system associated to the target system is a real-time operating system and at least an operating system associated to the host system is a general purpose operating system.

8. Avionics application host system according to any of the preceding claims, wherein the number of partitioned applications is ARINC 653 applications and the service module (150) is arranged to provide ARINC 653 services.

9. Avionics application host system according to claim 8, wherein ARINC 653 partition service is mapped to UNIX processes and the partitioned applications (A1-A4) are executed within its associated UNIX process as POSIX threads.

10. Flight simulator comprising an avionics applications host system according to any of claims 1-9, wherein the avionics application host system comprise an input module arranged to provide means to input control commands associated to simulated flight operations and wherein the avionics application host system comprise display means arranged to provide visual feedback based on the simulated flight operations.

11. Method for simulating and/or testing a number of partitioned applications arranged to be periodically executed on a target system, wherein the target system is a distributed avionics system of an aerial vehicle (1), wherein each of the applications may be divided into one or more partitions, and wherein each application comprises one or more tasks, the method comprising the steps of:
- importing the partitioned applications (S500) in un-modified binary format, compiled for the target system, into an avionics application host system,
- configuring operations (S510) of the avionics application host system associated to the partitioned applications (A1-A4) based on using configuration tables associated to the target system,
- initializing the imported partitioned applications (S520),
- wrapping requests for services related to execution from the imported partitioned applications (A1-A4) via wrapping layers to a control module (140), based on transmitting at least one message comprising information related to a requested execution start-time,
- granting execution time (S530) based on the requested execution start times,
- providing virtual communication (S540) based on transmitting at least one message comprising information related to a requested execution start-time from the communication module (142) to the control module (140),
- maintaining a simulated target system time and advancing the simulated target system time to the next requested start-time in order, so as to execute the imported partitioned applications and to preserve the temporal order of events related to communication and execution
**characterized by the steps of**
requesting, by means of the communication module (142), execution time based on one or more timed events from a predetermined traffic schedule associated to the target system, wherein static predetermined priorities are assigned to partitions prior to system run-time, to determine the order of execution of the partitions, such that during the execution time frame for the specific partition of the one or more partitions, the tasks associated to the specific partition is executed on a priority basis and each task is assigned a task frequency;
selecting the task processing frequency from a harmonic set of frequencies, wherein the task processing frequency of each specific task is selected on basis of how often input data are updated or how often subsequent input data changes in its parameter value and/or how often output data from the process is required by other parts of the system.

12. Method according to claim 11, **characterized in** comprising the further steps of:
- updating data (S550), said data comprising variables associated to a plurality of physical models, based on providing a request for execution time for processing of the physical models to the control module (140),
- exchanging variables between the partitioned applications (A1-A4) and variables associated to the plurality of physical models.

13. A computer program comprising instructions which, when executed on a computer, cause the computer to carry out the method steps of any of claims 11-12.

## Patentansprüche

1. Luftfahrtelektronik-Applikations-Hostsystem zum Simulieren und/oder Testen einer Anzahl von partitionierten Applikationen (A1-A4), die so ausgelegt sind, dass sie periodisch in einem Zielsystem ausgeführt werden, wobei das Zielsystem ein verteiltes Luftfahrtelektronik-Steuersystem eines Luftfahrtzeugs (1) ist, wobei jede der Applikationen in eine oder mehrere Partitionen aufgeteilt ist, und wobei jede Applikation eine oder mehrere Aufgaben umfasst, wobei das Hostsystem eine Anzahl von Funktionsmodulen umfasst, wobei die Anzahl von Funktionsmodulen umfasst:
- ein Applikationsmodul (146), das ausgelegt ist, um die Anzahl von partitionierten Applikationen (A1-A4) in unveränderter Binärform, erstellt für das Zielsystem, zu importieren,
- ein Konfigurationsmodul (145), das ausgelegt ist, um die Operationen des Hostsystems basierend auf mit dem Zielsystem verknüpften Konfigurationstabellen zu konfigurieren, wobei die Konfiguration der Operationen sich auf die Ausführungsspezifikationen, Kommunikation und den Speicherzugriff, mit den partitionierten Applikationen (A1-A4) verknüpft, bezieht,
- zumindest ein Kommunikationsmodul (142), das mit den importierten partitionierten Applikationen verknüpft ist, die ausgelegt sind, um Kommunikation zwischen den partitionierten Applikationen und zwischen Komponentenprozessen innerhalb der partitionierten Applikationen basierend auf den Konfigurationstabellen bereitzustellen,
- ein Steuermodul (140), das ausgelegt ist, um die abgestimmte Ausführungszeit zu den Funktionsmodulen basierend auf dem Empfangen einer Vielzahl von Aufforderungen nach einer Ausführungszeit von den Funktionsmodulen bereitzustellen, wobei jede der Vielzahl von Aufforderungen Informationen umfasst, die sich auf die aufgeforderte Ausführungsstartzeit beziehen, wobei das Steuermodul ferner dazu ausgelegt ist, die Ausführungsreihenfolge unter der Vielzahl von Aufforderungen basierend auf der aufgeforderten Ausführungsstartzeit zu bestimmen,
- ein Dienstmodul (150), das mit jeder partitionierten Applikation (A1-A4) verknüpft ist, welche dazu ausgelegt ist, Dienste an die importierten partitionierten Applikationen (A1-A4), die sich auf die Ausführung und Kommunikation über eine Standardzielapplikationsgrenzfläche beziehen, basierend auf Wrapping-Aufforderungen nach Diensten von den importierten partitionierten Applikationen (A1-A4) über eine Anzahl von Wrapper-Objekten (W1-W4) zum Kommunikationsmodul (142) und Steuermodul (140), bereitzustellen, um die Ausführung der importieren partitionierten Applikationen (A1-A4) zu ermöglichen, und um die zeitliche Reihenfolge von Ereignissen, die sich auf die Kommunikation und Ausführung beziehen, beizubehalten, **dadurch gekennzeichnet, dass**
das Kommunikationsmodul (142) für die Aufforderung nach einer Ausführungszeit basierend auf einem oder mehreren zeitlich festgelegten Ereignissen von einem mit dem Zielsystem verknüpften vorbestimmten Verkehrsplan ausgelegt ist, wobei statische vorbestimmte Prioritäten vor der Systemlaufzeit den Partitionen zugeordnet werden, um die Ausführungsreihenfolge der Partitionen zu bestimmen, so dass während des Ausführungszeitrahmens für die spezifische Partition der einen oder der mehreren Partitionen die mit der spezifischen Partition verknüpften Aufgaben auf einer Prioritätsbasis ausgeführt werden, und jede Aufgabe einer Aufgabenfrequenz zugeordnet wird, wobei die Aufgabenverarbeitungsfrequenz aus einer harmonischen Menge von Frequenzen ausgewählt wird, und wobei die Aufgabenverarbeitungsfrequenz von jeder spezifischen Aufgabe auf der Grundlage ausgewählt wird, wie oft Eingabedaten aktualisiert werden, oder wie oft nachfolgende Eingabedaten in ihrem Parameterwert sich ändern, und/oder wie oft Ausgabedaten aus dem Prozess von anderen Teilen des Systems benötigt werden.

2. Luftfahrtelektronik-Applikations-Hostsystem nach Anspruch 1, wobei das Steuermodul (140) ausgelegt ist, um gemäß einem Mitgliedschaftsprotokoll zu arbeiten, und mit den Funktionsmodulen den partitionierten Applikationen und den mit den partitionierten Applikationen verknüpften Komponentenprozessen basierend auf Nachrichtenschlangen-Objekten zu kommunizieren.

3. Luftfahrtelektronik-Applikations-Hostsystem nach einem der vorgehenden Ansprüche, wobei das Hostsystem ein Modellmodul (143) umfasst, das ausgelegt ist, um eine Vielzahl von physikalischen Modellen der Betriebsumgebung (ENV) des Zielsystems und der mit dem Zielsystem gekoppelten Subsysteme (AVS, SENS, ACT) bereitzustellen.

4. Luftfahrtelektronik-Applikations-Hostsystem nach Anspruch 3, wobei das Konfigurationsmodul (145) ferner ausgelegt ist, um eine Konfiguration bereitzustellen, welche zumindest eine der Anzahl von partitionierten Applikationen (A1-A4) mit zumindest einer Variablen zumindest einer der Vielzahl von physikalischen Modellen verknüpft.

5. Luftfahrtelektronik-Applikations-Hostsystem nach Anspruch 4, wobei das zumindest eine Kommunikationsmodul (142) eine Vielzahl von Kommunikations-Submodulen (V1-V2) umfasst, und das Konfigurationsmodul (145) ferner ausgelegt ist, um eine Konfiguration bereitzustellen, welche zumindest eine der Anzahl von partitionierten Applikationen (A1-A4) mit zumindest einer Variablen zumindest einer der Vielzahl von physikalischen Modellen über zumindest eines der Vielzahl von Kommunikations-Submodulen (V1-V2) verknüpft.

6. Luftfahrtelektronik-Applikations-Hostsystem nach Anspruch 5, wobei die Vielzahl von Kommunikations-Submodulen (V1-V2) Kommunikation zwischen Komponentenprozessen, die mit jeder der Anzahl von partitionierten Applikationen (A1-A4) verknüpft sind, basierend auf zumindest einem ersten geteilten Speicherobjekt (181-182), das mit jedem der Vielzahl von Kommunikations-Submodulen (V1-V2) verknüpft ist, bereitstellt, und wobei die Vielzahl von Kommunikations-Submodulen (V1-V2) Kommunikation zwischen der Anzahl von partitionierten Applikationen, die mit verschiedenen Kommunikations-Submodulen (V1-V2) verknüpft sind, basierend auf einem zweiten geteilten Speicherobjekt (185) bereitstellt.

7. Luftfahrtelektronik-Applikations-Hostsystem nach einem der vorgehenden Ansprüche, wobei zumindest ein mit dem Zielsystem verknüpftes Betriebssystem ein Echtzeit-Betriebssystem ist, und zumindest ein mit dem Hostsystem verknüpftes Betriebssystem ein im Allgemeinen für den Zweck verwendetes Betriebssystem ist.

8. Luftfahrtelektronik-Applikations-Hostsystem nach einem der vorgehenden Ansprüche, wobei die Anzahl von partitionierten Applikationen ARINC 653-Applikationen sind, und das Dienstmodul (150) zur Bereitstellung von ARINC 653-Diensten ausgelegt ist.

9. Luftfahrtelektronik-Applikations-Hostsystem nach Anspruch 8, wobei der ARINC 653-Partition-Dienst auf UNIX-Prozessen abgebildet wird, und die partitionierten Applikationen (A1-A4) innerhalb ihres verknüpften UNIX-Prozesses als POSIX-Threads ausgeführt werden.

10. Flugsimulator, der ein Luftfahrtelektronik-Applikations-Hostsystem nach einem der Ansprüche 1-9 umfasst, wobei das Luftfahrtelektronik-Applikations-Hostsystem ein Eingangsmodul umfasst, das ausgelegt ist, um Mittel zur Eingabe von mit simulierten Flugoperationen verknüpften Steuerbefehlen bereitzustellen, und wobei das Luftfahrtelektronik-Applikations-Hostsystem Anzeigemittel umfasst, welche ausgelegt sind, eine visuelle Rückmeldung basierend auf den simulierten Flugoperationen bereitzustellen.

11. Verfahren zum Simulieren und/oder Testen einer Anzahl von partitionierten Applikationen, die so ausgelegt sind, dass sie periodisch in einem Zielsystem ausgeführt werden, wobei das Zielsystem ein verteiltes Luftfahrtelektroniksystem eines Luftfahrtzeugs (1) ist, wobei jede der Applikationen in eine oder mehrere Partitionen aufgeteilt werden kann, und wobei jede Applikation eine oder mehrere Aufgaben umfasst, welches Verfahren die Schritte umfasst:
- Importieren der partitionierten Applikationen (S500) in unveränderter Binärform, erstellt für das Zielsystem, in ein Luftfahrtelektronik-Applikations-Hostsystem,
- Konfigurieren von Operationen (S510) des mit den partitionierten Applikationen (A1-A4) verknüpften Luftfahrtelektronik-Applikations-Hostsystems basierend auf der Verwendung von mit dem Zielsystem verknüpften Konfigurationstabellen,
- Initiieren der importieren partitionierten Applikationen (S520),
- Wrappen von Aufforderungen nach ausführungsbezogenen Diensten von den importierten partitionierten Applikationen (A1-A4) über Wrapping-Schichten zu einem Steuermodul (140) basierend auf der Übertragung zumindest einer Nachricht, welche Informationen umfasst, die sich auf eine aufgeforderte Ausführungsstartzeit beziehen,
- Gewähren der Ausführungszeit (S530) basierend auf den aufgeforderten Ausführungsstartzeiten,
- Bereitstellen einer virtuellen Kommunikation (S540) basierend auf der Übertragung zumindest einer Nachricht, die Informationen umfasst, die sich auf eine aufgeforderte Ausführungsstartzeit vom Kommunikationsmodul (142) zum Steuermodul (140) beziehen.
- Aufrechterhalten einer simulierten Zielsystemzeit und Vorrücken der simulierten Zielsystemzeit zur nächsten aufgeforderten Startzeit in der Reihenfolge, um die importierten partitionierten Applikationen auszuführen, und um die zeitliche Reihenfolge von auf die Kommunikation und Ausführung bezogenen Ereignissen beizubehalten
**gekennzeichnet durch die Schritte**
des Ausführens mittels des Kommunikationsmoduls (142) nach einer Ausführungszeit basierend auf einem oder mehreren zeitlich festgelegten Ereignissen von einem mit dem Zielsystem verknüpften vorbestimmten Verkehrsplan, wobei statische vorbestimmte Prioritäten vor der Systemlaufzeit den Partitionen zugeordnet werden, um die Ausführungsreihenfolge der Partitionen zu bestimmen, so dass während des Ausführungszeitrahmens für die spezifische Partition der einen oder der mehreren Partitionen die mit der spezifischen Partition verknüpften Aufgaben auf einer Prioritätsbasis ausgeführt werden, und jede Aufgabe einer Aufgabenfrequenz zugeordnet wird;
Auswählen der Aufgabenverarbeitungsfrequenz aus einer harmonischen Menge von Frequenzen, wobei die Aufgabenverarbeitungsfrequenz jeder spezifischen Aufgabe auf der Grundlage ausgewählt wird, wie oft Eingabedaten aktualisiert werden, oder wie oft nachfolgende Eingabedaten in ihrem Parameterwert sich ändern, und/oder wie oft Ausgabedaten aus dem Prozess von anderen Teilen des Systems benötigt werden.

12. Verfahren nach Anspruch 11, **dadurch gekennzeichnet, dass** es die weiteren Schritte umfasst:
- Aktualisieren von Daten (S550), welche Daten mit einer Vielzahl von physikalischen Modellen verknüpfte Variablen basierend auf dem Bereitstellen einer Aufforderung nach der Ausführungszeit zur Verarbeitung der physikalischen Modelle zu dem Steuermodul (140) umfassen,
- Austausch von Variablen zwischen den partitionierten Applikationen (A1-A4) und mit der Vielzahl von physikalischen Modellen verknüpften Variablen.

13. Computerprogramm, das Anweisungen umfasst, die beim Ausführen in einem Computer den Computer dazu veranlassen, die Verfahrensschritte nach einem der Ansprüche 11 bis 12 durchzuführen.

## Revendications

1. Système hôte d'application avionique pour simuler et / ou tester un certain nombre d'applications partitionnées (A1-A4) conçues pour être exécutées périodiquement sur un système cible, le système cible étant un système de commande avionique distribué d'un véhicule aérien (1), chacune des applications étant divisée en une ou plusieurs partitions, et chaque application comprenant une ou plusieurs tâches, le système hôte comprenant un certain nombre de modules fonctionnels, le nombre de modules fonctionnels comprenant :
- un module d'application (146) agencé pour importer ledit nombre d'applications partitionnées (A1-A4) sous une forme binaire non modifiée compilée pour le système cible,
- un module de configuration (145) agencé pour configurer les opérations du système hôte, sur la base de tables de configuration associées au système cible, ladite configuration des opérations portant sur des spécifications d'exécution, de communication et d'accès à la mémoire associées aux applications partitionnées (A1-A4),
- au moins un module de communication (142) associé aux applications partitionnées importées agencées pour assurer la communication entre les applications partitionnées et entre les processus composants au sein des applications partitionnées, basées sur lesdites tables de configuration,
- un module de contrôle (140) agencé pour fournir un temps d'exécution coordonné aux modules fonctionnels, basé sur la réception d'une pluralité de demandes de temps d'exécution des modules fonctionnels, chacune de la pluralité de demandes comprenant des informations relatives à l'heure de début d'exécution demandée, le module de commande étant en outre conçu pour déterminer l'ordre d'exécution parmi une pluralité de requêtes, sur la base de l'heure de début d'exécution demandée,
- un module de service (150) associé à chaque application partitionnée importée (A1-A4), conçu pour fournir des services aux applications partitionnées importées (A1-A4) portant sur l'exécution et à la communication via l'interface d'application cible standard, sur la base de l'enroulement de demandes de services depuis les applications partitionnées importées (A1-A4) via un certain nombre d'objets enveloppants (W1-W4) sur le module de communication (142) et le module de commande (140), afin de permettre l'exécution des applications partitionnées importées (A1-A4) et pour préserver l'ordre temporel des événements liés à la communication et à l'exécution, **caractérisé en ce que**
le module d communication (142) est agencé pour demander un temps d'exécution en fonction d'un ou de plusieurs événements temporisés d'un plan de transport prédéterminé associé au système cible, dans lequel des priorités statiques prédéterminées sont attribuées à des partitions avant le temps de passage du système, pour déterminer l'ordre d'exécution des partitions, si bien que lors de la trame de temps d'exécution pour la partition spécifique de l'une ou de plusieurs partitions, les tâches associées à la partition spécifique étant exécutées sur une base de priorité et chaque tâche étant attribuée à une fréquence de tâche, dans lequel la fréquence de traitement de tâches est sélectionnée parmi un ensemble harmonique de fréquences, et dans lequel la fréquence de traitement de tâches de chaque tâche spécifique est sélectionnée sur une base du nombre de fois que les données sont mises à jour ou du nombre de fois que des données d'entrée ultérieures sont changées dans leurs valeurs de paramètre et / ou le nombre de fois que des donnés d'entrée provenant du procédé sont demandées par d'autres parties du système.

2. Système hôte d'application avionique selon la revendication 1, dans lequel le module de commande (140) est conçu pour fonctionner conformément à un protocole d'appartenance et pour communiquer avec les modules fonctionnels, les applications partitionnées et les processus composants associés aux applications partitionnées, sur la base d'objets de la file d'attente de messages.

3. Système hôte d'application avionique selon l'une quelconque des revendications précédentes, dans lequel le système hôte comprend un module modèle (143) conçu pour fournir une pluralité de modèles physiques de l'environnement d'exploitation (ENV) du système cible et des sous-systèmes (AVS, SENS, ACT) couplés au système cible.

4. Système hôte d'application avionique selon la revendication 3, dans lequel ledit module de configuration (145) est en outre agencé pour fournir une configuration associant au moins l'une du nombre d'applications partitionnées (A1-A4) à au moins une variable d'au moins l'un de la pluralité modèles physiques.

5. Système hôte d'application avionique selon la revendication 4, dans lequel l'au moins un module de communication (142) comprend une pluralité de sous-modules de communication (V1 -V2), et le module de configuration (145) est en outre agencé pour fournir une configuration associant au moins l'une du nombre d'applications partitionnées (A1-A4) à au moins une variable d'au moins l'un de la pluralité modèles physiques via au moins un parmi la pluralité de sous-modules de communication (V1-V2).

6. Système hôte d'application avionique selon la revendication 5, dans lequel ladite pluralité de sous-modules de communication (V1-V2) fournit une communication entre des processus composants associés à chacun du nombre d'applications partitionnées (A1-A4) sur la base d'au moins un premier objet de mémoire partagée (181-182) associé à chacun de la pluralité de sous-modules de communication (V1-V2) et dans lequel la pluralité de sous-modules de communication (V1 -V2) assurent la communication entre le nombre d'applications partitionnées associées à différents sous-modules de communication (V1-V2) sur la base d'un deuxième objet de mémoire partagée (185).

7. Système hôte d'application avionique selon l'une quelconque des revendications précédentes, dans lequel au moins un système d'exploitation associé au système cible est un système d'exploitation en temps réel et au moins un système d'exploitation associé au système hôte est un système d'exploitation général.

8. Système hôte d'application avionique selon l'une quelconque des revendications précédentes, dans lequel le nombre d'applications partitionnées est des applications ARINC 653 et le module de service (150) est conçu pour fournir des services ARINC 653.

9. Système hôte d'application avionique selon la revendication 8, dans lequel le service de partition ARINC 653 est mappé sur des processus UNIX et les applications partitionnées (A1-A4) sont exécutées dans leur processus UNIX associé en tant que filetages POSIX.

10. Simulateur de vol comprenant un système hôte d'applications avioniques selon l'une quelconque des revendications 1 à 9, dans lequel le système hôte d'application avionique comprend un module d'entrée agencé pour fournir des moyens de commandes d'entrée associées à des opérations de vol simulées et dans lequel le système hôte d'application avionique comprend des moyens d'affichage agencés pour fournir une rétroaction visuelle basée sur les opérations de vol simulées.

11. Procédé pour simuler et / ou tester un certain nombre d'applications partitionnées conçues pour être exécutées périodiquement sur un système cible, le système cible étant un système de commande avionique distribué d'un véhicule aérien (1), chacune des applications étant divisée en une ou plusieurs partitions, et chaque application comprenant une ou plusieurs tâches, le procédé comprenant les étapes consistant à :
- importer les applications partitionnées (S500) sous une forme binaire non modifiée compilée pour le système cible, dans un système hôte d'application avionique,
- configurer des opérations (S510) du système hôte de l'application avionique associée aux applications partitionnées (A1-A4) sur la base de tables de configuration associées au système cible,
- initialiser les applications partitionnées importées (S520),
- enrouler des demandes de services liés à l'exécution des applications partitionnées importées (A1-A4) via des couches d'enroulement vers un module de commande (140), sur la base de la transmission d'au moins un message comprenant des informations relatives à une heure de début d'exécution demandée,
- assigner un temps d'exécution (S530) basé sur les heures de début d'exécution demandées,
- fournir une communication virtuelle (S540) basée sur la transmission d'au moins un message comprenant des informations relatives à une heure de début d'exécution demandée du module de communication (142) au module de commande (140),
- maintenir une heure système cible simulée et faire avancer l'heure système cible simulée à l'heure de début demandée suivante dans l'ordre, afin d'exécuter les applications partitionnées importées et de préserver l'ordre temporel des événements liés à la communication et à l'exécution,
**caractérisé par les étapes consistant à**
demander, au moyen du module de communication (142), un temps d'exécution en fonction d'un ou de plusieurs événements temporisés d'un plan de transport prédéterminé associé au système cible, dans lequel des priorités statiques prédéterminées sont attribuées à des partitions avant le temps de passage du système, pour déterminer l'ordre d'exécution des partitions, si bien que lors de la trame de temps d'exécution pour la partition spécifique de l'une ou de plusieurs partitions, les tâches associées à la partition spécifique étant exécutées sur une base de priorité et chaque tâche étant attribuée à une fréquence de tâche;
sélectionner la fréquence de traitement de tâches parmi un ensemble harmonique de fréquences, dans lequel la fréquence de traitement de tâches de chaque tâche spécifique est sélectionnée sur une base du nombre de fois que les données sont mises à jour ou du nombre de fois que des données d'entrée ultérieures sont changées dans leurs valeurs de paramètre et / ou le nombre de fois que des donnés d'entrée provenant du procédé sont demandées par d'autres parties du système.

12. Procédé selon la revendication 11, **caractérisé en ce qu'**il comprend en outre les étapes consistant à :
- mettre à jour des données (S550), lesdites données comprenant des variables associées à une pluralité de modèles physiques, sur la base de la fourniture d'une demande de temps d'exécution pour le traitement des modèles physiques au module de commande (140),
- échanger des variables entre les applications partitionnées (A1-A4) et les variables associées à la pluralité de modèles physiques.

13. Programme informatique comprenant des instructions qui, lorsqu'elles sont exécutées sur un processeur, amènent le processeur à effectuer le procédé selon l'une quelconque des revendications 11 à 12.
